# EUROPÄISCHE PATENTSCHRIFT

(11) **EP 3 425 289 B1**
(45) Veröffentlichungstag und Bekanntmachung des Hinweises auf die Patenterteilung: **23.10.2019**
(21) Anmeldenummer: 17179468.8
(22) Anmeldetag: 04.07.2017
(51) Int. Cl.: F24D 19/00, E03C 1/02

(54) **VERTEILERSCHRANK**
DISTRIBUTION CABINET
ARMOIRE DE DISTRIBUTION

(43) Veröffentlichungstag der Anmeldung: 09.01.2019
(73) Patentinhaber: STRAUB KG, 73337 Bad Überkingen (DE)
(72) Erfinder: STRAUB, Hans Jakob, 73337 Bad Überkingen (DE)
(74) Vertreter: Patentanwälte Geyer, Fehners & Partner mbB

(56) Entgegenhaltungen:
- EP-A1- 0 768 496
- EP-A2- 1 477 744
- EP-A2- 1 582 656
- EP-A2- 2 072 916

## Beschreibung

### Gebiet der Erfindung

Die Erfindung betrifft einen Verteilerschrank für die Sanitär- und/oder Heizungsinstallation in Gebäuden, beispielsweise für die Aufnahme und Halterung von Rohrverteilern sowie von Rohren, die zu dem Rohrverteiler hin und von diesem weg führen. Ein solcher Verteilerschrank umfasst einen Korpus, d.h. ein kastenförmiges Gehäuse mit einer Rückwand, einer oberen Wand und zwei Seitenteilen, alle Teile sind in der Regel aus Blech, beispielsweise feuerverzinktem Stahlblech gefertigt. Rückwand, obere Wand und die Seitenteile bilden den Korpus, der an seiner Unterseite offen ist, so dass durch die Unterseite Rohre in den Verteilerschrank geleitet werden können. Das kastenförmige Gehäuse ist an seiner Vorderseite offen, kann jedoch optional mit einem Türrahmen samt Tür versehen sein, um die Vorderseite zu verschließen. Im unteren Bereich des Korpus ist eine mit den Seitenteilen verbindbare Rohrumlenkschiene angeordnet. Im unteren Bereich des Korpus kann auch ein sogenanntes Estrichprallblech angeordnet sein, hinter dem dann die Rohrumlenkschiene angeordnet ist. An den Stirnseiten der oberen Wand und an den an die obere Wand anstoßenden Stirnseiten der Seitenteile sind Laschen ausgebildet, die zueinander korrespondieren, d.h., dass die Laschen an einer der jeweils aneinanderstoßenden Stirnseiten breiter als die Laschen der anderen jeweils aneinanderstoßenden Stirnseiten ausgebildet sind, und die breiteren Laschen Ösen zum Durchstecken der schmaleren Laschen aufweisen, und dass sie an zueinander korrespondierenden Positionen angeordnet sind, die ein Einstecken der einen Laschen in die Ösen der anderen Laschen ermöglicht.

### Stand der Technik

Solche Verteilerschränke werden in Gebäudeinstallationen zur Aufnahme von Baugruppen wie Vorlaufverteilern oder Rücklaufsammlern, für die Verzweigung von Heizungs- oder Wasserversorgungskreisen beim Betrieb mehrerer Versorgungskreise in einem Gesamtsystem eingesetzt. Es gibt sie in vielen verschiedenen Ausführungen. In der EP 0 768 496 B1 wird ein Verteilerschrank beschrieben, bei dem die Befestigung der Rohrumlenkschiene sowie des Prallblechs mittels einer Laschen-Steckverbindung erfolgt, was den werkzeuglosen Einbau dieser beiden Elemente in den Verteilerschrank ermöglicht. Das kastenförmige Gehäuse wird vormontiert geliefert, so dass logistisch entsprechend viel Platz benötigt wird.

Die Firma Selfio GmbH bietet Heizkreisverteilerschränke zur Selbstmontage an, welche als Bausatz geliefert werden, und bei denen zunächst die Seitenteile über Öffnungen, die an Abkantungen der Seitenteile angebracht sind, auf Laschen bzw. Haken gesteckt werden, die an der Rückwand ausgebildet sind. Anschließend wird die obere Wand mit den Seitenteilen und der Rückwand verschraubt. Die Laschen-Steckverbindung verhindert, dass die Seitenteile während der Anbringung der oberen Wand zur Seite kippen und in Richtung der Unterseite weggedrückt werden, bietet jedoch ausreichend Spiel, um eine Positionsanpassung im Rahmen von Toleranzen bei der Montage mit der oberen Wand vornehmen zu können. Die Zungen der Laschen zeigen in Richtung der oberen Wand, die Seitenteile müssen also in jedem Falle eingeschoben werden, bevor die obere Wand montiert wird. Die Montage eines solchen Heizkreisverteilers erfordert in jedem Fall Werkzeug und ist mit einem gewissen Zeitaufwand verbunden. Da die Zungen in Richtung der oberen Wand weisen, kann der Schrank beim Zusammenbau prinzipiell auch bei stehender Rückwand erfolgen.

Solche Laschen-Steckverbindungen für Gehäuseteile sind auch in anderen Bereichen bekannt, beispielsweise werden Computergehäuse oft mit Abdeckungen ausgestattet, die zunächst über Laschen an den Korpus gesteckt und dann mit diesem verschraubt werden. Ein solches Gehäuse ist beispielsweise in der US 6,382,744 B1 beschrieben, die an der Abdeckung angebrachten Laschen weisen hier eine zusätzliche Biegung nach außen auf, die das Einführen in die an dem Korpus angebrachten Öffnungen erleichtert. In der US 2007/0284977 A1 wird ein ähnliches Computergehäuse beschrieben, bei dem eine Abdeckung mittels einer Laschen-Steckverbindung mit dem übrigen Gehäuse zusammengefügt wird, bevor die Teile an einer Seite, an der sich der Griff befindet, miteinander verschraubt werden.

In der DE 24 15 532 A1 ist eine Tragvorrichtung für Kabelkanäle offenbart. Diese umfasst Vertikalträger, in welche Löcher eingebracht sind. In diese Löcher sind horizontale Tragarme einhängbar, wozu an den Tragarmen Haken zum Hintergreifen des Vertikalträgers im Bereich der Löcher angeordnet sind. Um horizontal wirkende Kräfte besser aufnehmen zu können, sind die Schnittkanten zur Erzeugung des Hakens aus der Wand des Tragarmes in vertikaler Richtung unterschiedlich lang, so dass zur Aufnahme von horizontalen Kräften am Haken eine größere Fläche an einem der Hakenränder zur horizontalen Abstützung bereitgestellt wird.

Bei den oben beschriebenen Verteilerschränken und Gehäusen sind entweder die Gehäuse bis auf eine Abdeckung vormontiert, so dass für den Transport und die Lagerung ein hoher Platzbedarf besteht, oder aber zur Montage ist Werkzeug erforderlich, was in der Regel dem Schrank nicht beiliegt und den Zeit- und Materialaufwand für den Zusammenbau erhöht.

Ein Verteilerschrank, der im Wesentlichen ohne Werkzeug zusammengebaut werden kann und welcher im unmontierten Zustand als gegenüber dem zusammengebauten Schrank flaches Paket gelagert werden kann, wird in der EP 1 477 744 B1 beschrieben, die als nächster Stand der Technik angesehen wird. Bei diesem Verteilerschrank sind Rückwand, Seitenteile und obere Wand einstückig gefertigt, wobei gestanzte Stege die Seitenteile und die obere Wand jeweils mit der Rückwand schwenkbeweglich miteinander verbinden. Auf diese Weise ist eine flache Lagerung möglich. Zur Montage müssen die Seitenteile und die obere Wand jeweils in einem Winkel von 90° zur Rückwand umgebogen werden. An den Stirnseiten der Seitenteile und der oberen Wand sind Laschen ausgebildet, welche zueinander korrespondieren. Dabei sind die Laschen der oberen Wand breiter als die Laschen an den Seitenteilen und weisen schlitzförmige Ösen auf, durch die die schmaleren Laschen hindurchgesteckt werden. Anschließend werden die Laschen in den Seitenteilen um jeweils 90° umgebogen, so dass die Seitenteile mit der Wand an den Stirnseiten formschlüssig miteinander verbunden sind. Auf die Offenbarung der EP 1 477 744 B1 wird explizit Bezug genommen, ihr Inhalt wird hier mit einbezogen.

Der in der EP 1 477 744 B1 beschriebene Verteilerschrank lässt sich zwar ohne Werkzeuge montieren, bei der Stanzung des einstückigen Grundgerüsts aus einer großen Blechplatte entsteht jedoch viel Materialabfall, was die Herstellungskosten erhöht. Da das Grundgerüst aus einer rechteckigen Platte ausgestanzt und dann gefaltet wird, fallen pro Schrank regelmäßig mindestens Materialstücke mit etwa quadratischer Form und der Kantenlänge, die der Länge der Kante einer der Stirnseiten eines Seitenteils bzw. der oberen Wand entspricht, als Abfall an. Je tiefer also ein solcher Verteilerschrank ist, desto mehr Abfall entsteht.

### Beschreibung der Erfindung

Die Aufgabe der Erfindung besteht daher darin, einen Verteilerschrank der eingangs beschriebenen Art zu entwickeln, dessen Korpus sich einerseits werkzeuglos mit wenigen Handgriffen zusammenbauen lässt, der sich darüber hinaus für logistische Zwecke vor dem Zusammenbau flach verpacken lässt, und bei dessen Herstellung der Materialaufwand möglichst gering gehalten wird, so dass der Materialabfall minimiert wird.

Diese Aufgabe wird durch die Merkmale des Anspruchs 1 gelöst. Hierbei wird bei einem Verteilerschrank der eingangs beschriebenen Art die Rückwand mit den Seitenteilen und der oberen Wand kraft- und formschlüssig über Steckverbindungsmittel zusammengefügt. Dabei bestehen die Steckverbindungsmittel aus mehreren, jeweils an der Rückwand und/oder an Abkantungen der Seitenteile und der oberen ausgestanzten und aus einer Blechebene herausgebogenen Hakenteilen sowie dazu korrespondierend aus mehreren an den Abkantungen der Seitenteile und der oberen Wand bzw. der Rückwand angeordneten Durchbrüchen. Die in der Regel als Flachhaken ausgebildeten Hakenteile bilden mit dem Blech im Bereich der Seite des Bleches, die den Hakenteilen zugewandt ist, eine Federklammer. Dazu ist den Hakenteilen vorzugsweise eine Biegung und/oder eine Auswölbung in Richtung des Bleches eingeprägt.

Die Rückwand, die obere Wand und die Seitenteile werden einzeln gefertigt, so dass der Materialverbrauch reduziert werden kann. Beim Zusammenbau werden die obere Wand und die beiden Seitenteile nacheinander durch die Steckverbindungsmittel mit der Rückwand verbunden, wobei konstruktiv darauf zu achten ist, dass zunächst ein Teil mit der Rückwand verbunden wird, an dem die breiteren Laschen mit Ösen ausgebildet sind, durch die dann die schmaleren Laschen des als nächsten zu verbindenden Teils beim Zusammensetzen geführt werden können. Für den Zusammenbau ist es vorteilhaft, wenn die Hakenteile an der Rückwand ausgebildet sind, da letztere dann während des Zusammenbaus flach auf einer Arbeitsunterlage gelagert werden kann, ohne bewegt werden müssen.

Beim Zusammenbau werden in diesem Fall die obere Wand bzw. die Seitenteile mit den entsprechenden, an Abkantungen ausgebildeten Öffnungen über den an der Rückwand ausgebildeten Hakenteilen platziert, abgesenkt und sodann in Richtung des Hakens, d.h. der Stelle, wo diese aus dem Blech der Rückwand herausgebogen ist und einen Anschlag bildet, verschoben. Während bei Haken bzw. Laschen, wie sie im Stand der Technik in diesem Zusammenhang bekannt sind, dann nur eine formschlüssige Verbindung in Einschubrichtung sowie senkrecht dazu entsteht, haben die Haken, die hier als flächige Laschen oder Flachhaken ausgebildet sind, im Zusammenspiel mit dem Blech auch eine Klemmwirkung, die beispielsweise durch die zusätzliche Biegung bzw. Auswölbung in Richtung des Bleches erreicht werden kann. Auf diese Weise wird zum einen verhindert, dass die Teile durch Spiel senkrecht zur Blechebene sich seitlich beim Zusammenbau bewegen können, was das Einführen der schmaleren Laschen in die Ösen an den breiteren Laschen erleichtert. Zum anderen bewirkt die Ausbildung der Hakenteile mit dem Blech als Federklemme, dass der Verteilerschrank nicht nur in liegender Position zusammengebaut werden kann, sondern auch bei einer beispielsweise schräg an der Wand stehenden Rückwand, wenn beispielsweise der für den Zusammenbau zur Verfügung stehende Platz beschränkt ist. Auch ein Transport eines nur teilweise zusammengefügten Verteilerschranks - beispielsweise auf der Baustelle - wird auf diese Weise vereinfacht. Da die obere Wand mit den Seitenteilen bzw. Seitenwänden über Laschen, die durch Ösen gesteckt werden, verbunden wird, muss der Zusammenbau so gestaltet werden, dass zunächst ein Teil mit der Rückwand zusammengefügt wird, bei dem die breiteren Laschen mit Ösen ausgebildet sind, durch die dann im nächsten Schritt die schmaleren Laschen eines zweiten Teils gesteckt werden. Wird zunächst die obere Wand mit der Rückwand verbunden, müssen anschließend die Seitenteile von der Seite auf die Haken gesteckt werden, die der oberen Wand gegenüberliegt. Beginnt man mit einem Seitenteil, so muss als nächstes die obere Wand und anschließend das zweite Seitenteil mit der Rückwand verbunden werden. Somit müssen die Hakenteile in jedem Falle für mindestens eine der Seitenwände nach unten geöffnet sein.

Sind die breiteren Laschen mit Ösen sämtlich an der oberen Wand ausgebildet, so ist zwar grundsätzlich auch eine Montage bei auf dem Kopf stehenden Schrank möglich. Wird der Schrank dann jedoch für den Einbau umgedreht, so müssen die umgebogenen Laschen der Seitenteile deren ganzes Gewicht gegen die obere Wand abstützen, wenn die Verbindung der Seitenteile mit der Rückwand wie im Stand der Technik nur formschlüssig und nicht zusätzlich kraftschlüssig erfolgt. Durch die Federklammerfunktion der als Flachhaken ausgebildeten Hakenteile werden die Laschen also hinsichtlich der an ihnen anliegenden Kraft entlastet.

In einer vorteilhaften Ausgestaltung sind die Seitenteile und die obere Wand als Stanzteile aus einem Stahlblechband vorgegebener Breite ausgebildet. An die Stanzteile werden nach dem Stanzen noch Falze bzw. Abkantungen um 90° durch Biegung angeformt. Hier können insbesondere aufgerollte Bänder aus Stahl oder einem anderen, für die Herstellung von Verteilerschränken zugelassenen Metall, verwendet werden, was eine äußerst platzsparende Lagerung und Fertigung ermöglicht.

Die Ausbildung der Seitenteile und der oberen Wand als derartige Stanzteile aus einem aufgerollten Band erlaubt zum einen eine einfache Anpassung an verschiedenen Rückwandgrößen, da entsprechend der Breite oder der Höhe der Rückwand einfach mehr oder weniger von dem Band abgeschnitten bzw. herausgestanzt wird. Zum anderen ist auch eine Anpassung an verschiedene Schranktiefen ohne Materialverlust möglich, da in diesem Falle nur zu einem Band anderer Breite gewechselt werden muss.

Vorteilhaft ist die untere Führungsleiste bereits durch Biegung als Doppelfalz an der Unterseite der Rückwand angeformt. Unabhängig davon kann auch die obere Führungsleiste schon im Herstellungsprozess eines Bausatzes für einen solchen Verteilerschrank stoffschlüssig - beispielsweise durch Punktschweißen - mit der Rückwand verbunden werden, dies ist mit weniger Aufwand als im Falle eines einstückigen Verbundes zwischen Rückwand, Seitenteilen und oberer Wand möglich, da die Rückwand als Einzelteil weniger Platz benötigt und somit auch die entsprechenden Maschinen bei einer mindestens teilweise automatisierten Fertigung weniger Platz benötigen. Selbstverständlich ist es auch möglich, die obere Führungsleiste separat zu fertigen und mit der Rückwand kraft- und formschlüssig zu verbinden, beispielsweise durch die Ausbildung ähnlicher Hakenteile mit Klemmwirkung wie im Falle der Steckverbindungsmittel für die Seitenteile, die obere Wand und die Rückwand, oder aber eine Verbindung vorzusehen, wie sie in der EP 1 477 744 B1 beschrieben ist. Die werkseitige Anbringung der oberen Führungsleiste erleichtert und verkürzt jedoch den Zusammenbau des Verteilerschranks.

Der oben beschriebene Verteilerschrank lässt sich - vor dem Zusammenbau - flach lagern und transportieren, optional mit einer Tür und einem Türrahmen. Er ist zudem - bis auf den Türrahmen - werkzeuglos zusammensetzbar, bei seiner Herstellung wird der Materialabfall äußerst gering gehalten. Prallblech und Rohrumlenkschiene können ebenso werkzeuglos in dem Schrank eingesetzt werden, wie dies beispielsweise in der EP 1 477 744 B1 beschrieben ist, auf die hier ausdrücklich Bezug genommen wird.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

### Kurze Beschreibung der Zeichnungen

Nachfolgend wird die Erfindung beispielsweise anhand der beigefügten Zeichnungen, die auch erfindungswesentliche Merkmale offenbaren, noch näher erläutert. Es zeigen
Fig. 1a) einen Verteilerschrank in Perspektivansicht,
Fig. 1b) ein Detail aus Fig. 1a),
Fig. 1c) den Verteilerschrank aus Fig. 1a) ohne Tür von vorne,
Fig. 2a) die Rückwand eines Verteilerschranks,
Fig. 2b) ein Detail aus Fig. 2a),
Fig. 3 eine obere Wand eines Verteilerschranks, und
Fig.4a, b) ein Seitenteil eines Verteilerschranks aus zwei verschiedenen Richtungen.

### Ausführliche Beschreibung der Zeichnungen

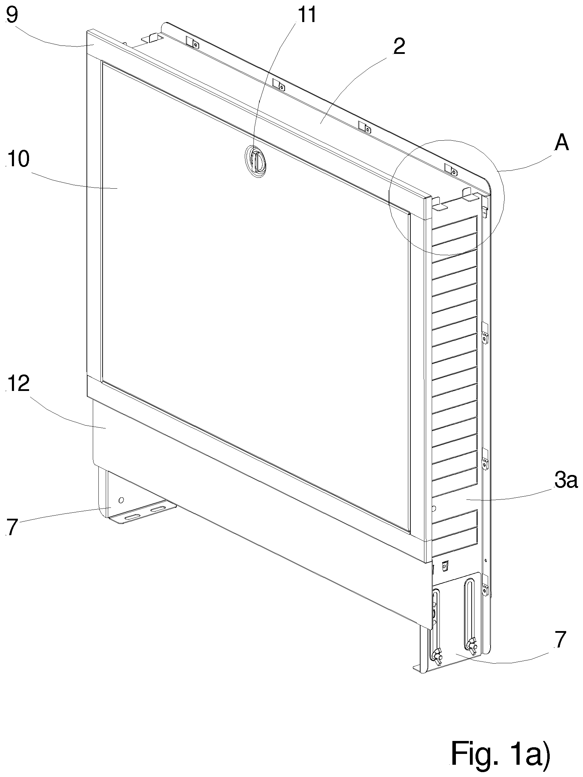

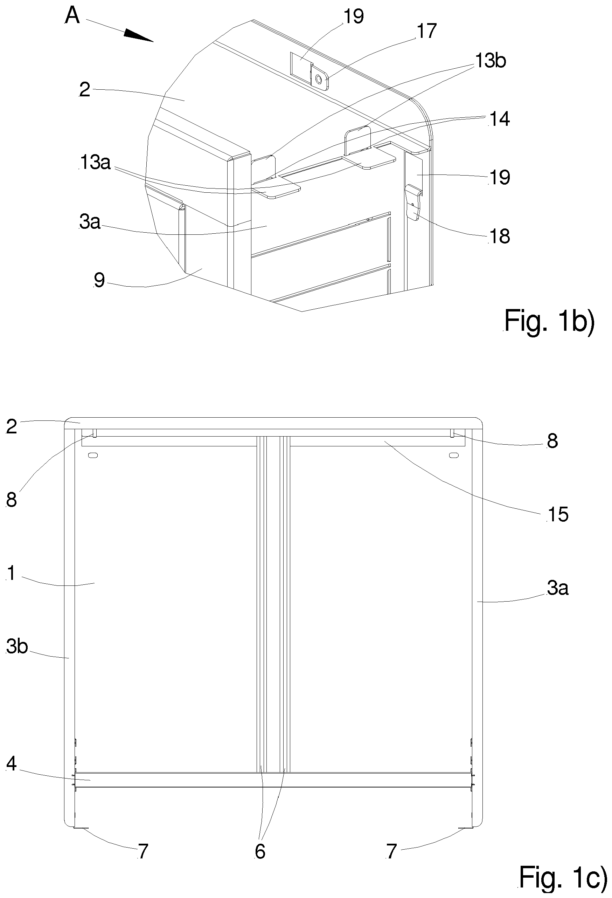

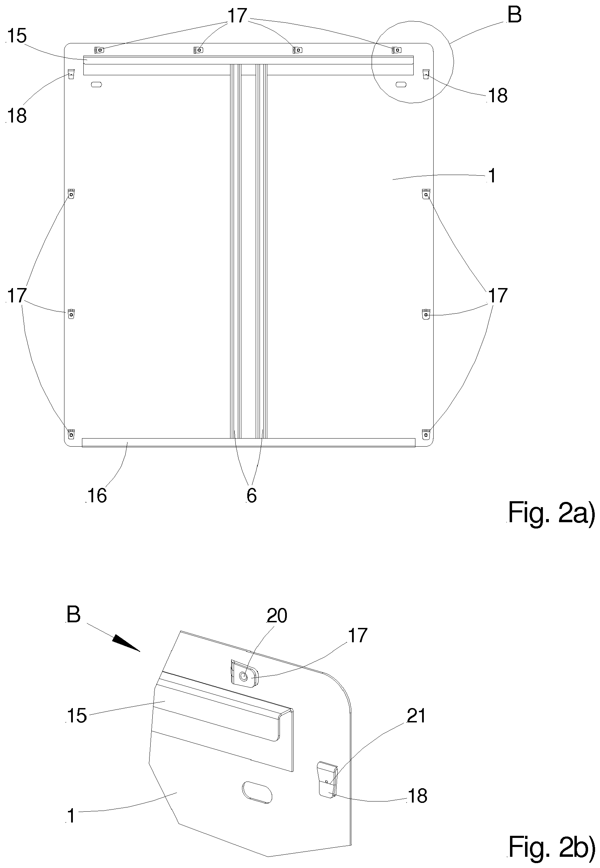

Fig. 1 zeigt einen Verteilerschrank für die Sanitär- oder Heizungsinstallation in Gebäuden. Fig. 1a) zeigt den Verteilerschrank in Perspektivansicht, Fig. 1b) ein Detail aus Fig. 1a und Fig. 1c) eine Frontansicht eines Korpus des Verteilerschranks. Der Verteilerschrank umfasst den in Fig. 1c) dargestellten Korpus mit einer Rückwand 1, einer oberen Wand 2, einem rechten Seitenteil 3a und einem linken Seitenteil 3b. Die Rückwand 1, die obere Wand 2 und die beiden Seitenteile 3a, 3b sind in der Regel aus Blech, beispielsweise aus Stahlblech gefertigt, bevorzugt als Stanzteile aus einem aufgerollten Metallband, das während der Herstellung sukzessive abgerollt wird. Im unteren Bereich des Korpus ist eine mit den Seitenteilen 3a, 3b während des Zusammenbaus bevorzugt werkzeuglos kraft- und formschlüssig verbindbare und hier schon verbundene Rohrumlenkschiene 4 angeordnet, dargestellt in Fig 1c). Im Schrankinneren sind eine obere Führungsleiste 15 und eine untere Führungsleiste 16 - zu sehen in Fig. 2a) - für die Anbringung von Befestigungsleisten angeordnet, die untere Führungsleiste 16 wird in Fig. 1c) von der Rohrumlenkschiene 4 verdeckt und liegt in Blickrichtung hinter dieser. Die obere Führungsleiste 15 und die untere Führungsleiste 16 dienen der Anbringung von Befestigungsleisten 6 auf im Stand der Technik bekannte Weise. Die Befestigungsleisten 6 können beispielsweise in die Führungsleisten eingeklemmt werden.

Im untersten Bereich des Korpus sind die Seitenteile 3a, 3b nach unten über die Höhe der Rückwand 1 überstehend ausgebildet. An den so gebildeten Vorsprüngen ist jeweils ein in der Höhe verstellbares und in einer eingestellten Höhe fixierbares Fußteil 7 angeordnet. Bei den Fußteilen 7 handelt es sich um Hilfsmittel für die Positionierung und Befestigung des Korpus in einer Wandnische für die Unterputz-Montage. Im unteren Bereich des rechten Seitenteils 3a und des linken Seitenteils 3b sowie an der oberen Wand 2 sind nach innen abstehende Gewindebolzen 8 angeordnet. Sie ragen in den Innenraum hinein und sind für die Befestigung von Laschen eines optional anzubringenden Türrahmens 9 vorgesehen, der auf diese Weise am Korpus positioniert und arretiert werden kann. Die Vorderseite des Verteilerschranks mit den Fußteilen 7 und dem Türrahmen 9 ist in Fig. 1a) dargestellt. In den Türrahmen 9 wurde eine Tür 10 mit einem Schloss 11 eingesetzt. Unterhalb des Türrahmens 9 wird die Rohrumlenkschiene 4 von einem Prallblech 12 verdeckt, welches auf im Stand der Technik bekannte Weise ebenso wie die Rohrumlenkschiene 4 mit dem Korpus über Steckverbindungen verbunden werden kann. Dazu sind an den Seitenteilen 3a, 3b Stecklaschen ausgebildet, in welche Stege am Prallblech 12 und an der Rohrumlenkschiene 4 eingesteckt werden können, wie dies beispielsweise in der EP 1 477 744 B1 beschrieben ist.

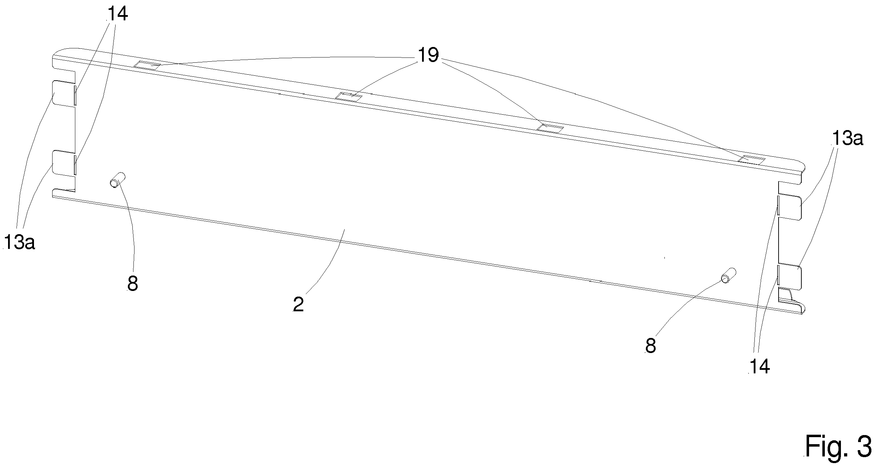

Die Verbindung der oberen Wand 2 mit dem rechten Seitenteil 3a und dem linken Seitenteil 3b erfolgt über Laschen 13a, 13b und Ösen 14, wie dies in Fig. 1b), die ein Detail aus Fig.1a) zeigt, dargestellt ist. Dazu sind an den Stirnseiten der oberen Wand 2 und an den an die obere Wand 2 anstoßenden Stirnseiten der Seitenteile 3a, 3b zueinander korrespondierend Laschen 13a, 13b ausgebildet. Dabei sind die Laschen 13a an einer der jeweils aneinanderstoßenden Stirnseiten breiter als die Laschen 13b an der anderen der jeweils aneinander stoßenden Stirnseiten ausgebildet. An den breiteren Laschen 13a - hier beispielhaft an der oberen Wand 2 angebracht - sind Ösen 14, gezeigt in Fig. 3, zum Durchstecken der schmaleren Laschen 13b ausgebildet. Nach dem Zusammenstecken - in Fig.1b) gezeigt - werden die Laschen 13a, 13b jeweils zu den Flächen der anliegenden anderen Wand umgebogen, um eine formschlüssige Verbindung der Seitenteile 3a, 3b mit der oberen Wand 2 herzustellen. Um das Umbiegen per Hand zu erleichtern, können auch die schmaleren Laschen 13b Ösen oder Perforierungen, die durch Stanzen erzeugt werden können, aufweisen.

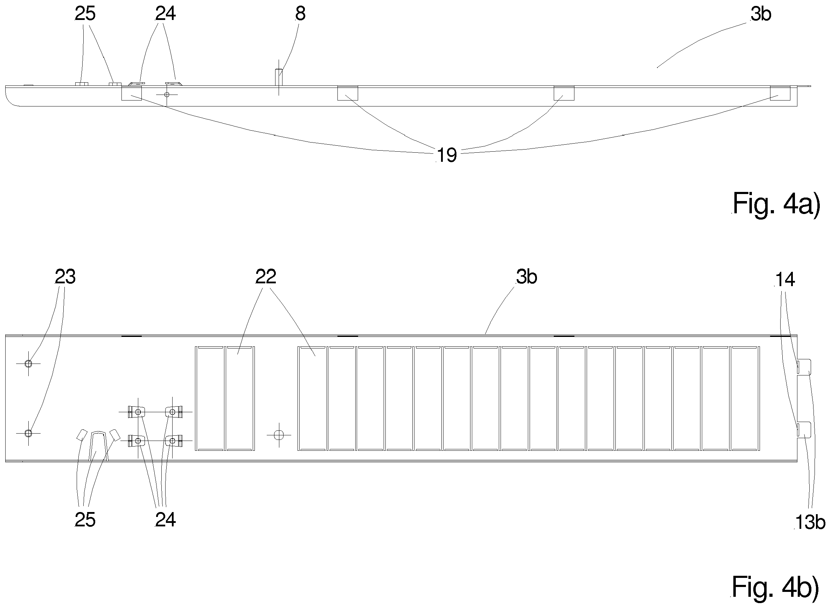

Die Rückwand 1 ist in Fig. 2a) in einer Projektionsansicht von vorne gezeigt, Fig. 2b) zeigt ein Detail der Rückwand 1 in Perspektivansicht. Die obere Wand 2 ist in Perspektivansicht in Fig. 3 gezeigt, dort sind auch die Ösen 14 an den Laschen 13a zu erkennen. Fig. 4a) schließlich zeigt das linke Seitenteil 3b in Draufsicht auf die Seitenfläche, Fig. 4b zeigt das linke Seitenteil 3b mit Blick auf die hintere, mit der Rückwand 1 zu verbindende Kante.

Fig. 2a) zeigt die Rückwand 1. Oben an der Rückwand ist eine U-förmige obere Führungsleiste 15 mit der Rückwand 1 verbunden, bevorzugt erfolgt die Verbindung stoffschlüssig durch Punktschweißen an verschiedenen Punkten entlang der Länge der oberen Führungsleiste 15. Die Schenkel des U sind verschieden lang. An der Unterkante der Rückwand 1 ist eine untere Führungsleiste 16 angeformt, im vorliegenden Fall durch Biegung eines Doppelfalzes, d.h. einer zweifachen Biegung der unteren Kante der Rückwand 1 um je 90°. Dabei wird - um die Verbindung der Rückwand 1 mit den beiden Seitenteilen 3a, 3b nicht zu behindern - die Kante nicht über die gesamte untere Seitenlänge gebogen, sondern weist in dem zu biegenden Bereich einen entsprechend dimensionierten Überstand aus, so dass nach der Biegung kein Überstand mehr vorhanden ist und die Befestigungsleisten 6 in die Führungsleiste 16 eingesetzt werden können. Alternativ ist auch in diesem Fall eine stoffschlüssige Verbindung einer gesondert gefertigten Führungsleiste wie im Fall der oberen Führungsleiste 15 möglich.

Im montierten Zustand ist die Rückwand 1 mit den Seitenteilen 3a und 3b und der oberen Wand 2 kraft- und formschlüssig über Steckverbindungsmittel zusammengefügt. Die Steckverbindungsmittel bestehen dabei aus mehren, jeweils an der Rückwand 1 oder an Abkantungen der Seitenteile 3a, 3b und der oberen Wand 2 ausgestanzten und aus einer Blechebene heraus gebogenen Hakenteilen, sowie dazu korrespondierend aus mehreren an Abkantungen der Seitenteile 3a, 3b und der oberen Wand 2 bzw. der Rückwand 1 angeordneten Durchbrüchen. Im vorliegenden Fall sind mehrere aus der Rückwand 1 ausgestanzte und aus der Blechebene herausgebogene Hakenteile 17 und 18 vorgesehen, alternativ können die Hakenteile auch an den Seitenteilen 3a, 3b und/oder der oberen Wand 2 ausgebildet sein. Die in Fig. 2a) gezeigte Ausführung erleichtert jedoch das Zusammenfügen der Teile bei liegender Rückwand 1. Entsprechende, zu den Hakenteilen 17 und 18 korrespondiere Öffnungen 19 sind im gezeigten Beispiel an der oberen Wand 2 und an den Seitenteilen 3a, 3b ausgebildet. In Fig. 4a, b) ist nur das linke Seitenteil 3b gezeigt, das rechte Seitenteil 3a ist zu diesem bezüglich der Blattebene als Spiegelebene spiegelsymmetrisch aufgebaut. Beim Zusammenbau wird zunächst die obere Wand 2 mit den Öffnungen 19 über den Hakenteilen 17 und 18 platziert, so dass die Hakenteile 17 und 18 durch die Öffnungen 19 hindurchtreten. Anschließend wird die obere Wand 2 in Richtung der Biegekante, d.h. der Kante, an der der Haken 17 bzw. 18 aus der Blechebene heraus gebogen sind, verschoben, diese Kante dient auch als Anschlag. Die Hakenteile 17 und 18 bilden dabei mit dem Blech, aus dem sie heraus gebogen wurden, eine Federklammer, so dass die obere Wand 2 und entsprechend auch die Seitenteile 3a, 3b, nachdem diese eingesetzt wurden, auch kraftschlüssig mit der Rückwand 1 verbunden sind. Um die Wirkung einer Federklammer zu erreichen, gibt es verschiedene Möglichkeiten, von denen in Fig. 2b), die ein Detail der Rückwand 1 an der oberen Ecke in Perspektivansicht zeigt, zwei mögliche Ausgestaltungen dargestellt sind. Den Hakenteilen 17 ist dabei eine Auswölbung in Richtung des Bleches eingeprägt, die einen Druckpunkt definiert, über den das Hakenteil mit dem Blech der eingeschobenen oberen Wand 2 in Kontakt steht. Sämtliche Hakenteile 17 und 18 sind herstellungsbedingt als Flachhaken ausgebildet. Durch die Einprägung einer Auswölbung 20 nach unten, beispielsweise mit Hilfe eines entsprechenden Prägestempels im Rahmen der Ausstanzung des Hakens, wird einerseits eine kraftschlüssige Verbindung zwischen Rückwand 1 und Seitenteilen 3a, 3b bzw. oberer Wand 2 hergestellt, andererseits wird das Einschieben der oberen Wand 2 bzw. der Seitenteile 3a, 3b nicht unnötig erschwert.

Eine andere Möglichkeit besteht darin, dem Hakenteil eine Biegung in Richtung des Bleches, aus dem es heraus gebogen wurde, einzuprägen, wie dies beim Hakenteil 18 der Fall ist. Dies ist in Richtung der Blechkante gebogen, so dass das lose Ende des Hakenteils 18 grundsätzlich in Richtung des Bleches der Rückwand 1 zeigt. Um das Einschieben der Seitenteile 3a und 3b zu erleichtern, ist dem Hakenteil 18 eine weitere Biegung mit einer weiteren Biegekante 21 aufgeprägt, die das lose Ende des Hakenteils 18 wieder vom Blech der Rückwand 1 wegbiegt. Der kraftschlüssige Kontakt mit dem eingeschobenen Seitenteil 3a, 3b entsteht hier entlang der weiteren Biegekante 21.

Fig. 4a, b) zeigt schließlich das linke Seitenteil 3b. Im oberen Teil des Seitenteiles 3b und entsprechend auch des nicht gezeigten Seitenteiles 3a sind Abdeckungen 22 von Durchbrüchen eingezeichnet, die Randbereiche dieser Durchbrüche sind durch Stanzung perforiert, so dass ein Installateur bei Bedarf entsprechend viele Abdeckungen 22 von den Durchbrüchen mit geringem Aufwand herausnehmen kann, um an diesen geöffneten Durchbrüchen Rohre hindurchzuführen. Im unteren Bereich sind Löcher 23 angeordnet, durch diese können Schrauben zur Verbindung der Fußteile 7 mit dem Seitenteil 3b bzw. 3a hindurchgeführt werden. Prallblechlaschen 24 dienen dem Einstecken von entsprechenden am Prallblech 12 ausgebildeten Laschen, Rohrumlenklaschen 25 dienen der Befestigung der Rohrumlenkschiene 4.

Die Seitenteile 3a, 3b und die obere Wand 2 sind bevorzugt aus einem Stahlblechband gestanzt, wobei die Breite des Blechbandes abhängig von der nötigten Schranktiefe gewählt werden kann. Entsprechend ist auch eine einfache und variable Anpassung an verschiedene Schrankhöhen und -breiten möglich, indem die Ablängung des Blechbandes variiert wird.

Bei dem in Fig. 1 - 4 gezeigten Verteilerschrank sind die Hakenteile 17 und 18 an der Rückwand 1 für die Aufnahme der Seitenteile 3a, 3b nach unten geöffnet, d.h. sie sind von der oberen Wand 2 in die entgegengesetzte Richtung weisend ausgebildet, so dass die Seitenteile 3a, 3b nach dem Einsetzen mit den Öffnungen 19 auf die Hakenteile 17 bzw. 18 in Richtung der oberen Wand 2 geschoben werden müssen, um die gewünschte kraftschlüssige Verbindung herzustellen, wenn auch die obere Wand 2 von der Seite eingeschoben werden soll - was einfacher handhabbar ist als ein Einschieben von oben oder unten, d.h. senkrecht zu den Großflächen der oberen Wand 2. Beim Zusammenbau wird daher zunächst die obere Wand 2 mit der Rückwand 1 kraft- und formschlüssig verbunden, bevor die Seitenteile 3a, 3b eingesetzt werden. Gleichzeitig mit der Herstellung der kraftschlüssigen Verbindung der Seitenteile 3a, 3b mit der Rückwand 1 werden auch die Laschen 13b durch die Ösen 14 der Laschen 13a an der oberen Wand 2 geschoben. Anschließend werden die Laschen 13a, 13b umgebogen, um die formschlüssige Verbindung der oberen Wand 2 mit den Seitenteilen 3a, 3b herzustellen. Schließlich wird noch die Rohrumlenkschiene 4 auf im Stand der Technik bekannte Weise eingesetzt. Alle vorangehend beschriebenen Schritte lassen sich manuell und ohne Werkzeug durchführen. Der Korpus ist dann vormontiert und kann in eine entsprechende Öffnung in der Wand eingebaut werden, wahlweise zunächst auch mit einem Türrahmen 9 zur Anbringung einer Tür 10 versehen werden.

Durch die in entgegengesetzte Richtung von der oberen Wand 2 weisende Ausbildung derjenigen Hakenteile 17 und 18, die für die Verbindung der Seitenteile 3a, 3b mit der Rückwand 1 vorgesehen sind, und durch die Federklammerwirkung der Hakenteile mit dem Blech, aus dem sie heraus gestanzt und gebogen wurden, ist es möglich, auch die obere Wand 2 werkzeuglos mit der Rückwand 1 und den Seitenteilen 3a, 3b zu verbinden. Dazu müssen für mindestens eines der beiden Seitenteile 3a, 3b die Hakenteile 17, 18 nach unten geöffnet sein.

Der vorangehend beschriebene Verteilerschrank lässt sich mit wenig Materialverlust herstellen, ist werkzeuglos montierbar, wobei durch die kraftschlüssige Verbindung der Seitenteile 3a, 3b und der oberen Wand 2 mit der Rückwand 1 in jedem Falle eine einfache und sichere Montage auch auf engem Raum gewährleistet ist.

### Bezugszeichenliste

- 1: Rückwand
- 2: obere Wand
- 3a, 3b: Seitenteil
- 4: Rohrumlenkschiene
- 5: freibleibend
- 6: Befestigungsleiste
- 7: Fußteile
- 8: Gewindebolzen
- 9: Türrahmen
- 10: Tür
- 11: Schloss
- 12: Prallblech
- 13a, 13b: Lasche
- 14: Öse
- 15: obere Führungsleiste
- 16: untere Führungsleiste
- 17, 18: Hakenteile
- 19: Öffnung
- 20: Auswölbung
- 21: Biegekante
- 22: Abdeckung
- 23: Loch
- 24: Prallblechlasche
- 25: Rohrumlenklasche

## Patentansprüche

1. Verteilerschrank für die Sanitär- und/oder Heizungsinstallation in Gebäuden, umfassend
- einen Korpus mit einer Rückwand (1), einer oberen Wand (2) und zwei Seitenteilen (3a, 3b), jeweils aus Blech,
- eine im unteren Bereich des Korpus angeordnete, mit den Seitenteilen (3a, 3b) verbindbare Rohrumlenkschiene (4), und
- im Schrankinneren eine obere Führungsleiste (15) und eine untere Führungsleiste (16) für Befestigungsleisten (6),
- an den Stirnseiten der oberen Wand (2) und an den an die obere Wand (2) anstoßenden Stirnseiten der Seitenteile (3a, 3b) zueinander korrespondierend ausgebildete Laschen (13a, 13b), wobei die Laschen (13a) an einer der jeweils aneinander stoßenden Stirnseiten breiter als die Laschen (13b) an der anderen der jeweils aneinander stoßenden Stirnseiten ausgebildet sind, und die breiteren Laschen (13a) Ösen (14) zum Durchstecken der schmaleren Laschen (13b) aufweisen,
- **dadurch gekennzeichnet, dass**
- die Rückwand (1) mit den Seitenteilen (3a, 3b) und der oberen Wand (2) kraft- und formschlüssig über Steckverbindungsmittel zusammengefügt ist,
- wobei die Steckverbindungsmittel aus mehreren, jeweils an der Rückwand (1) und/oder an Abkantungen der Seitenteile (3a, 3b) und der oberen Wand (2) ausgestanzten und aus einer Blechebene heraus gebogenen Hakenteilen (17, 18) sowie dazu korrespondierend aus mehreren an den Abkantungen der Seitenteile (3a, 3b) und der oberen Wand (2) bzw. der Rückwand (1) angeordneten Öffnungen (19) bestehen, und
- wobei die Hakenteile (17, 18) mit dem Blech, aus dem sie heraus gebogen sind, eine Federklammer bildend ausgestaltet sind.

2. Verteilerschrank nach Anspruch 1, **dadurch gekennzeichnet, dass** den Hakenteilen (17, 18) zur Bildung der Federklammer eine Biegung und/oder eine Auswölbung (20) in Richtung des Bleches eingeprägt ist.

3. Verteilerschrank nach Anspruch 1 oder 2, **dadurch gekennzeichnet, dass** die Hakenteile (17, 18) an der Rückwand (1) ausgebildet sind und die zur Verbindung der Rückwand (1) mit den Seitenteilen (3a, 3b) vorgesehenen Hakenteile (17, 18) nach unten geöffnet sind.

4. Verteilerschrank nach Anspruch 1 oder 2, **dadurch gekennzeichnet, dass** Seitenteile (3a, 3b) und obere Wand (2) als Stanzteile aus einem Stahlblechband vorgegebener Breite ausgebildet sind.

5. Verteilerschrank nach einem der Ansprüche 1 bis 3, **dadurch gekennzeichnet, dass** die obere Führungsleiste (15) stoffschlüssig mit der Rückwand verbunden ist und/oder die untere Führungsleiste (16) durch Biegung an die Rückwand angeformt ist.

## Claims

1. Distribution cabinet for sanitary and/or heating installation in buildings, comprising
- a body with a rear wall (1), an upper wall (2) and two side parts (3a, 3b), each made of sheet metal,
- a pipe diversion rail (4) connectable to the side parts (3a, 3b) arranged in the lower area of the body, and
- an upper guide rail (15) and a lower guide rail (16) inside the cabinet for mounting rails (6),
- tabs (13a, 13b) formed corresponding to one another on the end faces of the upper wall (2) and on the end faces of the side parts (3a, 3b) adjoining the upper wall (2), wherein the tabs (13a) on one of the end faces adjoining one another in each case are formed wider than the tabs (13b) on the other of the end faces adjoining one another in each case, and the wider tabs (13a) have eyelets (14) for inserting the narrower tabs (13b) through,
- **characterized in that**
- the rear wall (1) is non-positively and positively joined to the side parts (3a, 3b) and the upper wall (2) by plug connection means,
- wherein the plug connection means consist of several hook parts (17, 18) stamped out in each case in the rear wall (1) and/or in folded edges of the side parts (3a, 3b) and of the upper wall (2) and bent out from a sheet plane, as well as of several openings (19), corresponding thereto, arranged on the folded edges of the side parts (3a, 3b) and of the upper wall (2) or of the rear wall (1), respectively, and
- wherein the hook parts (17, 18), with the sheet metal from which they are bent out, are designed forming a spring clip.

2. Distribution cabinet according to claim 1, **characterized in that** a bend and/or a curvature (20) in the direction of the sheet metal is stamped into the hook parts (17, 18) for forming the spring clip.

3. Distribution cabinet according to claim 1 or 2, **characterized in that** the hook parts (17, 18) are formed on the rear wall (1) and the hook parts (17, 18) provided for connecting the rear wall (1) to the side parts (3a, 3b) are opened downwards.

4. Distribution cabinet according to claim 1 or 2, **characterized in that** side parts (3a, 3b) and upper wall (2) are formed as parts stamped from a steel strip of predetermined width.

5. Distribution cabinet according to one of claims 1 to 3, **characterized in that** the upper guide rail (15) is materially bonded to the rear wall and/or the lower guide rail (16) is formed by bending on the rear wall.

## Revendications

1. Armoire de distribution pour l'installation de sanitaire et/ou de chauffage dans des bâtiments, comportant
- un corps ayant une paroi arrière (1), une paroi supérieure (2) et deux parties latérales (3a, 3b), chacune étant réalisée en tôle de métal,
- un rail de dérivation de tuyau (4) en mesure d'être raccordé aux parties latérales (3a, 3b), agencé dans la zone inférieure du corps, et
- un rail de guidage supérieur (15) et un rail de guidage inférieur (16) à l'intérieur de l'armoire pour des rails de montage (6),
- des pattes (13a, 13b) formées pour se correspondre les unes par rapport aux autres sur les faces d'extrémité de la paroi supérieure (2) et sur les faces d'extrémité des parties latérales (3a, 3b) de manière adjacente par rapport à la paroi supérieure (2), dans laquelle les pattes (13a) sur l'une des faces d'extrémité adjacentes les unes par rapport aux autres dans chaque cas sont formées pour être plus larges que les pattes (13b) sur l'autre des faces d'extrémité adjacentes les unes par rapport aux autres dans chaque cas, et les pattes plus larges (13a) ont des oeillets (14) servant à des fins d'insertion des pattes plus étroites (13b) au travers de ceux-ci,
- **caractérisée en ce que**
- la paroi arrière (1) est jointe de manière non positive et de manière positive aux parties latérales (3a, 3b) et à la paroi supérieure (2) par des moyens de connexion enfichables,
- dans laquelle les moyens de connexion enfichables sont composés de plusieurs parties formant crochets (17, 18) découpées par estampage dans chaque cas dans la paroi arrière (1) et/ou dans des bords repliés des parties latérales (3a, 3b) et de la paroi supérieure (2) et cintrés vers l'extérieur depuis un plan de tôle, ainsi que plusieurs ouvertures (19), correspondant à ceux-ci, agencées sur les bords repliés des parties latérales (3a, 3b) et de la paroi supérieure (2) ou de la paroi arrière (1), respectivement, et
- dans laquelle les parties formant crochets (17, 18), avec la tôle de métal en provenance de laquelle elles sont cintrées vers l'extérieur, sont conçues pour former une pince à ressort.

2. Armoire de distribution selon la revendication 1, **caractérisée en ce qu'**un coude et/ou une courbe (20) dans la direction de la tôle de métal est découpé par estampage dans les parties formant crochets (17, 18) pour former la pince à ressort.

3. Armoire de distribution selon la revendication 1 ou 2, **caractérisée en ce que** les parties formant crochets (17, 18) sont formées sur la paroi arrière (1) et les parties formant crochets (17, 18) prévues pour raccorder la paroi arrière (1) aux parties latérales (3a, 3b) sont ouvertes vers le bas.

4. Armoire de distribution selon la revendication 1 ou 2, **caractérisée en ce que** des parties latérales (3a, 3b) et une paroi supérieure (2) sont formées sous la forme de parties découpées par estampage en provenance d'une bande d'acier d'une largeur prédéterminée.

5. Armoire de distribution selon l'une des revendications 1 à 3, **caractérisée en ce que** le rail de guidage supérieur (15) est relié de façon matérielle à la paroi arrière et/ou le rail de guidage inférieur (16) est formé par cintrage sur la paroi arrière.
